# EUROPEAN PATENT APPLICATION

(11) **EP 4 138 122 A1**
(43) Date of publication of application: **22.02.2023**
(21) Application number: 22185620.6
(22) Date of filing: 19.07.2022
(51) Int. Cl.: H01L 21/8234, H01L 27/088

(54) **SELF-ALIGNED GATE CUT STRUCTURES**

(30) Priority: 19.08.2021 US 202117406480
(71) Applicant: INTEL Corporation, Santa Clara, CA 95054 (US)
(72) Inventor: WEI, Andy Chih-Hung, Yamhill 97148 (US); MURTHY, Anand S., Portland 97229 (US); CHENG, Yang-Chun, Portland 97229 (US); PEARCE, Ryan, Beaverton 97007 (US); BOUCHE, Guillaume, Portland 97211 (US)
(74) Representative: 2SPL Patentanwälte PartG mbB

(57) **Abstract**

Techniques are provided herein to form semiconductor devices having self-aligned gate cut structures. Neighboring semiconductor devices each include a semiconductor region (110) extending between a source region and a drain region, and a gate layer (116) extending over the semiconductor regions of the neighboring semiconductor devices. A gate cut structure (118) that includes a dielectric material interrupts the gate layer between the neighboring semiconductor devices. Due to the process of forming the gate cut structure, the distance between the gate cut structure and the semiconductor region of one of the neighboring semiconductor devices is substantially the same as (e.g., within 1.5 nm of) the distance between the gate cut structure and the semiconductor region of the other one of the neighboring semiconductor devices.

## Description

### FIELD OF THE DISCLOSURE

The present disclosure relates to integrated circuits, and more particularly, to gate cut structures.

### BACKGROUND

As integrated circuits continue to scale downward in size, a number of challenges arise. For instance, reducing the size of memory and logic cells is becoming increasingly more difficult. Certain aspects of lithography technology can impose physical limits on how accurately certain structures can be aligned. Alignment errors can lead to low yield and/or devices that operate slightly differently from one another which can cause timing errors or other failures. Accordingly, there remain a number of non-trivial challenges with respect to structure alignment in semiconductor devices.

### BRIEF DESCRIPTION OF THE DRAWINGS

Figure 1 is a cross-sectional view of some semiconductor devices that illustrates one or more gate cut structures that are self-aligned between adjacent devices, in accordance with an embodiment of the present disclosure.
Figures 2A - 2L' are cross-sectional views that illustrate various stages in an example process for forming an integrated circuit configured with one or more self-aligned gate cut structures, in accordance with an embodiment of the present disclosure.
Figure 3 illustrates a cross-section view of a chip package containing one or more semiconductor dies, in accordance with some embodiments of the present disclosure.
Figure 4 is a flowchart of a fabrication process for a semiconductor device having self-aligned gate cut structures, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles, and some features may have surface topology or otherwise be non-smooth, given real world limitations of the processing equipment and techniques used.

### DETAILED DESCRIPTION

Techniques are provided herein to form semiconductor devices having self-aligned gate cut structures. The techniques can be used in any number of integrated circuit applications and are particularly useful with respect to logic and memory cells, such as those cells that use finFETs or gate-all-around transistors. In an example, neighboring semiconductor devices each include a semiconductor region extending between a source region and a drain region, and a gate layer extending over the semiconductor regions of the neighboring semiconductor devices. A gate cut structure that includes a dielectric material interrupts the gate layer between the neighboring semiconductor devices thus isolating the gate of one semiconductor device from the gate of the other semiconductor device. Due to the process of forming the gate cut structure, the distance between the gate cut structure and the semiconductor region of one of the neighboring semiconductor devices is substantially the same as the distance between the gate cut structure and the semiconductor region of the other one of the neighboring semiconductor devices (e.g., such as the example case where the two distances are within 1 nm of each other, or closer). This highly accurate alignment is nearly impossible to consistently achieve using conventional masking techniques. Numerous variations and embodiments will be apparent in light of this disclosure.

### General Overview

As previously noted above, there remain a number of non-trivial challenges with respect to alignment of particular semiconductor structures. In more detail, gate cut structures are commonly provided between adjacent semiconductor devices to isolate the gate layer that crosses over each of the adjacent semiconductor devices. Accordingly, gate cut structures are important for the formation of integrated circuits to successfully isolate the gates of two devices from one another. Ideally, the gate cut structure is to be placed directly in the middle between the adjacent semiconductor devices to ensure the same amount of gate material around all sides of each of the semiconductor regions of the semiconductor devices. In practice, however, this is difficult to achieve as alignment tolerances during the masking and lithography process often cause the gate cut to be formed closer to one semiconductor region vs the other. Additionally, due to some other masking limitations, gate cut structures are typically one size anywhere across the integrated circuit.

Thus, and in accordance with an embodiment of the present disclosure, techniques are provided herein to form self-aligned gate cut structures that do not rely on the limitations imposed by conventional lithography. During the formation of the semiconductor devices, spacer structures are formed on the sidewalls of adjacent semiconductor fins to form a region between the spacer structures that is self-aligned to be centralized between the adjacent semiconductor fins. This region can be filled with a sacrificial material that has sufficient etch selectivity to the material used for the spacers in order to selectively remove the sacrificial material and replace it with a suitable gate cut material, such as silicon nitride. Ultimately, the resulting gate cut structures are self-aligned between a first and a second adjacent semiconductor device such that the distance between the gate cut structure and the semiconductor region of the first semiconductor device is substantially the same as the distance between the gate cut structure and the semiconductor region of the second semiconductor device. As used herein, distances that are substantially the same to one another are within 1.5 nm of each other according to some embodiments, such as the example case where the distances are within 1 nm or less of each other, or the example case where the distances are within 0.5 nm or less of each other. In any such cases, the distance can be measured at a consistent height or otherwise within the same imaginary horizontal plane that passes through each of the semiconductor regions and the gate cut structure, such as at the one-third-point or midpoint of the gate cut structure, or a midpoint of the gated portion of the fins. Additionally, the disclosed process for forming the gate cut structures yields gate cut structures that can have different widths across the integrated circuit depending on the distance between the adjacent semiconductor devices.

According to an embodiment, an integrated circuit includes a first semiconductor device having a first semiconductor region extending between a first source region and a first drain region, and a second semiconductor device having a second semiconductor region extending between a second source region and a second drain region. The integrated circuit further includes a gate layer comprising a conductive material that extends over the first semiconductor region and the second semiconductor region, and a gate cut structure that comprises a dielectric material. The gate cut structure is between the first semiconductor device and the second semiconductor device such that the gate cut structure interrupts the gate layer where a first distance between the gate cut structure and the first semiconductor region is substantially the same as a second distance between the gate cut structure and the second semiconductor region (e.g., such as the example case where the two distances are within 1 nm of each other, or closer.

According to another embodiment, a method of forming an integrated circuit includes forming a first fin comprising first semiconductor material and a second fin comprising second semiconductor material, wherein the first fin and the second fin extend parallel to one another, the first fin having a first cap structure on a top surface of the first fin and the second fin having a second cap structure on a top surface of the second fin; forming a first spacer structure comprising a first material on at least a first side of the first fin facing the second fin and a second spacer structure comprising the first material on at least a second side of the second fin facing the first fin; depositing a second material different from the first material into a region between the first and second spacer structures; removing the cap structure and depositing the first material onto the top surface of the first fin and the second fin; removing the second material from between the first and second spacer structures; depositing a dielectric material into the region between the first and second spacer structures; and forming a gate over the first semiconductor material and over the second semiconductor material, wherein the dielectric material interrupts the gate between the first semiconductor material and the second semiconductor material.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate substantially the same distance between the gate cut structure and each of the semiconductor regions of adjacent semiconductor devices, as variously explained herein (e.g., where the distances between the gate cut structure and each of the semiconductor regions of adjacent semiconductor devices are within 1.5 nm or less of each other, such as within 1 nm of each other). In some other example embodiments, such tools may indicate different gate cut structures having different sizes (e.g., different widths) between different sets of semiconductor devices. In some other example embodiments, the distance between all gate cut structures and any adjacent semiconductor region is substantially the same, as variously explained herein. Numerous configurations and variations will be apparent in light of this disclosure.

### Architecture

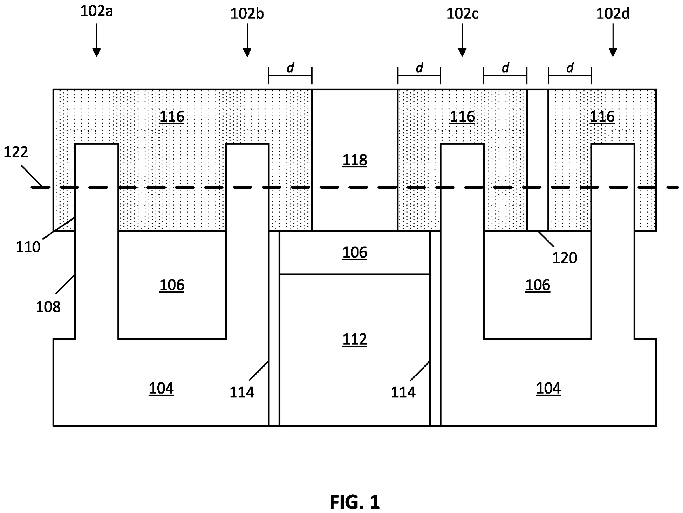

Figure 1 is a cross sectional view taken across a plurality of semiconductor devices 102a - 102d, according to an embodiment of the present disclosure. Each of semiconductor devices 102a - 102d may be non-planar metal oxide semiconductor (MOS) transistors, such as tri-gate or gate-all-around (GAA) transistors, although other transistor topologies and types could also benefit from the techniques provided herein.

As can be seen, semiconductor devices 102a - 102d are formed on a substrate 104. Any number of semiconductor devices can be formed on substrate 104, but four are used here as an example. Substrate 104 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used.

The semiconductor material in each of semiconductor devices 102a - 102d may be formed from substrate 104. Semiconductor devices 102a - 102d may each include fins that can be, for example, native to substrate 104 (formed from the substrate itself) as illustrated, such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches.

As can further be seen, adjacent semiconductor devices are separated by a dielectric fill 106 that may include silicon oxide. Dielectric fill 106 provides shallow trench isolation (STI) between any adjacent semiconductor devices. Dielectric fill 106 can be any suitable dielectric material, such as silicon dioxide, aluminum oxide, or silicon oxycarbonitride.

Focusing on semiconductor device 102a, but applicable to all semiconductor devices, semiconductor device 102a includes a subfin region 108 and a semiconductor region 110. According to some embodiments, subfin region 108 comprises the same semiconductor material as substrate 104 and is adjacent to dielectric fill 106. According to some embodiments, semiconductor region 110 extends above the top surface of dielectric fill 106 and provides an active region for a transistor (e.g., the semiconductor region beneath the gate).

As noted above, semiconductor region 110 may represent a fin of semiconductor material or several nanowires or nanoribbons that extend between a source region and a drain region. The source and drain regions are not shown in this particular cross-section. According to some embodiments, the source and drain regions are epitaxial regions that are provided on the fins in an etch-and-replace process. In other embodiments one or both of the source and drain regions could be, for example, implantation-doped native portions of the fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used.

In some embodiments, a buried conductive layer 112 is provided within the substrate and adjacent to one or more of the semiconductor devices. In the illustrated example, buried conductive layer 112 is provided within a portion of substrate 104 between semiconductor device 102b and semiconductor device 102c. Buried conductive layer 112 can be any conductive material, such as any metal or metal alloy, that may include any of tungsten, molybdenum, ruthenium, cobalt, copper, aluminum, or silver. According to some embodiments, buried conductive layer 112 provides a VDD or VSS power rail to various semiconductor devices of the integrated circuit. According to some embodiments, liner dielectric layers 114 are provided on either side of buried conductive layer 112 to provide electrical isolation between buried conductive layer 112 and any neighboring semiconductor devices. Liner dielectric layers 114 may include silicon oxide or silicon nitride. Liner dielectric layers 114 can be relatively thin, such as 2 to 6 nm, or thinner so long as it electrically isolates buried conductive layer 112 from the neighboring semiconductor devices, for the given application.

According to some embodiments, a gate layer 116 extends over the semiconductor regions 110 of semiconductor devices 102a - 102d. It should be noted that a gate dielectric layer would also be present between the semiconductor regions 110 and gate layer 116 and is not shown for clarity. Gate layer 116 may include any sufficiently conductive material such as a metal, metal alloy, or doped polysilicon. According to some embodiments, gate layer 116 may be interrupted between any adjacent semiconductor devices by a gate cut structure such as gate cut 118 or gate cut 120. The gate cut structures effectively isolate portions of gate layer 116 from one another to form electrically separate gates for certain semiconductor devices. In the illustrated example, a portion of gate layer 116 connects the gates of both semiconductor devices 102a and 102b while gate cut 118 and gate cut 120 isolates a portion of gate layer 116 only over semiconductor device 102c. Similarly, gate cut 120 isolates a portion of gate layer 116 over only semiconductor device 102d.

Each of gate cut 118 and 120 may be formed from a sufficiently insulating material, such as a dielectric material. Example materials for gate cut 118 and 120 include silicon nitride, silicon oxide, or silicon oxynitride. According to some embodiments, gate cut 118 and gate cut 120 are formed using a spacer process, as will be discussed herein, which self-aligns gate cut 118 at the midpoint between semiconductor device 102b and semiconductor device 102c and also self-aligns gate cut 120 at the midpoint between semiconductor device 102c and semiconductor device 102d. Accordingly, the gate cut structures may each be aligned at a distance d from the adjacent semiconductor regions 110 of the adjacent semiconductor devices. As noted above, each distance d is substantially the same (e.g., each distance d is within 1 nm of each other, or within 5 angstroms of each other). The distance d may vary between applications, but in some examples is between about 5 nm and about 25 nm. Further note that distance d can be measured in a consistent fashion, such as the example case where distance d is measured in an imaginary horizontal plane that passes through each of gate cuts 118 and 120 as well as the fins, such as the illustrated example with dashed line 122. Since the size of a given gate cut structure is determined by the distance between the adjacent semiconductor structures, gate cut structures of different sizes (e.g., different widths) can be formed across the integrated circuit. In the illustrated example, gate cut 120 has a smaller width than gate cut 118 because semiconductor devices 102c and 102d are closer together compared to semiconductor devices 102b and 102c. Furthermore, since the gate cut structures do not rely on traditional lithographic patterning, they can be made very small. In some embodiments, gate cut 118 and gate cut 120 each have a width between about 5 nm and about 20 nm.

### Fabrication Methodology

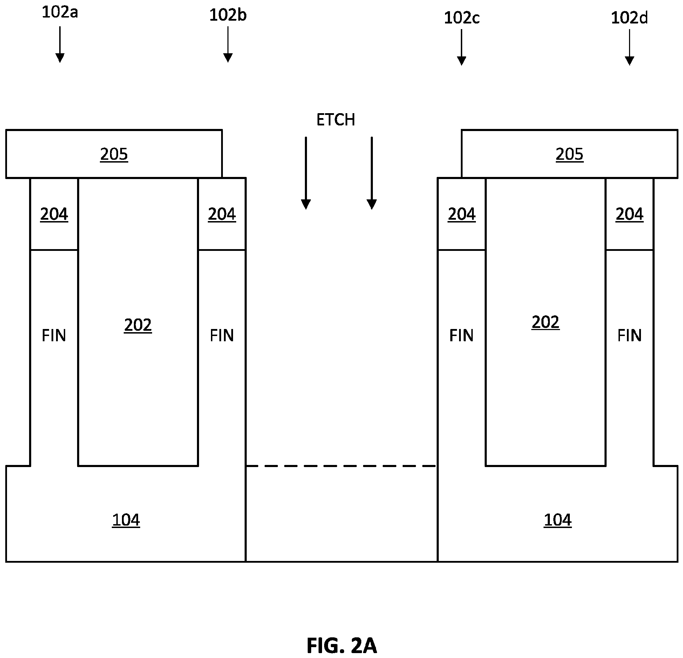

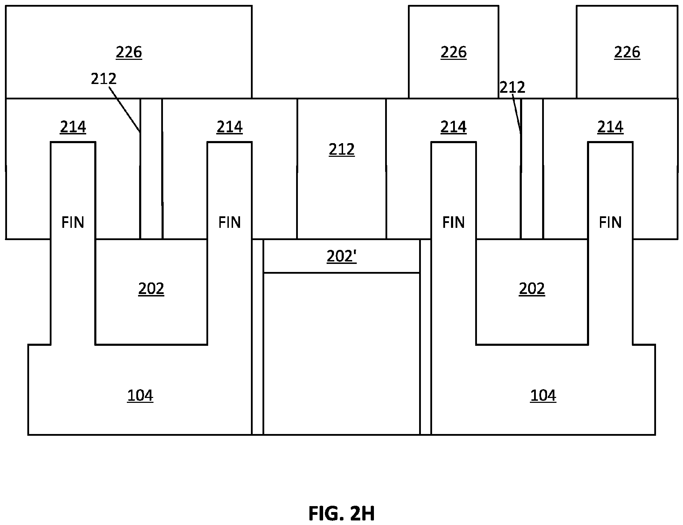

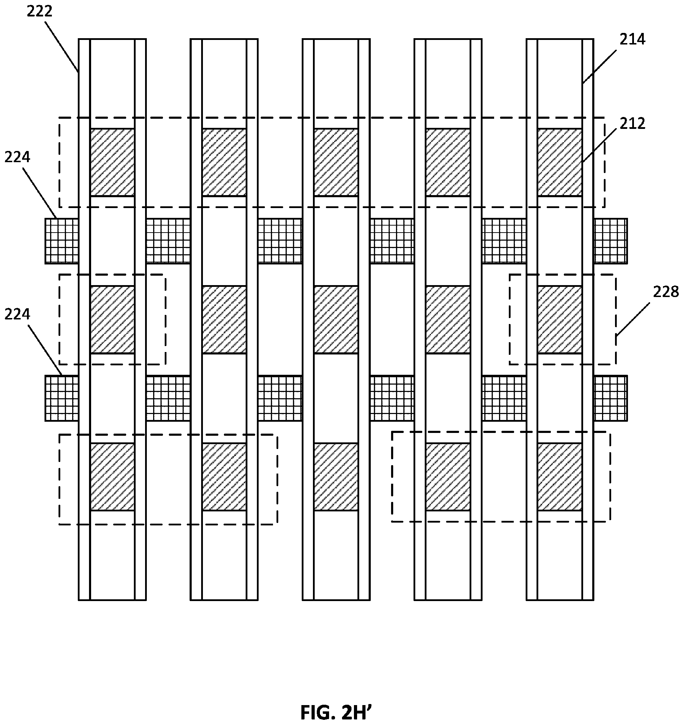

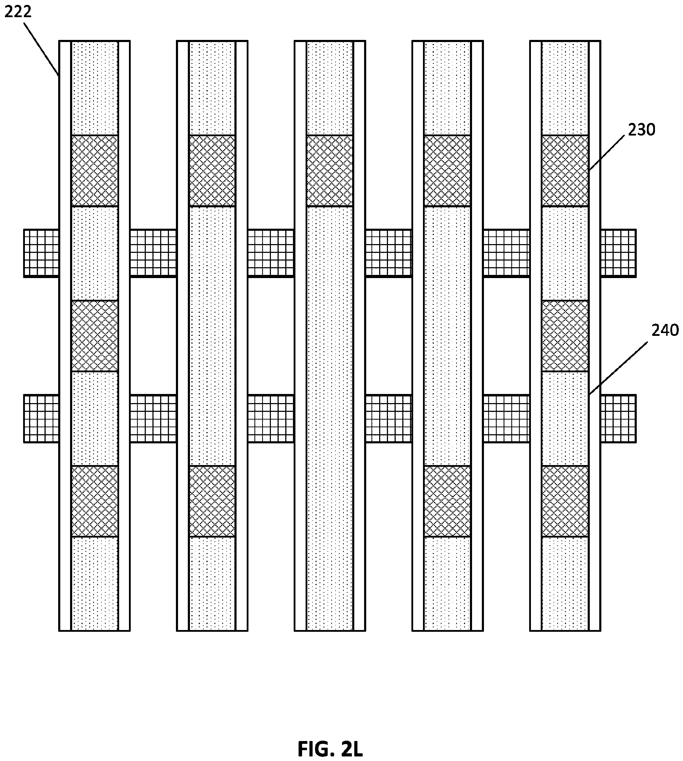

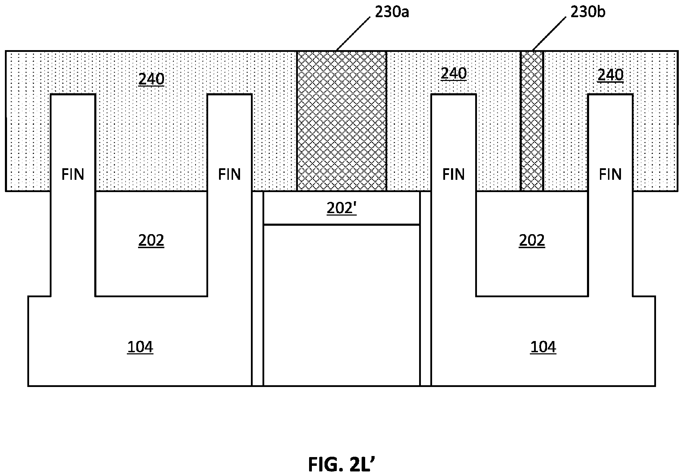

Figures 2A - 2L' are cross-sectional or top-down views that collectively illustrate an example process for forming an integrated circuit configured with self-aligned gate cut structures, in accordance with an embodiment of the present disclosure. Each figure shows an example structure that results from the process flow up to that point in time, so the depicted structure evolves as the process flow continues, culminating in the structure shown in Figures 2L and 2L', which is similar to the structure illustrated in Figure 1. Such a structure may be part of an overall integrated circuit (e.g., such as a processor or memory chip) that includes, for example, digital logic cells and/or memory cells and analog mixed signal circuitry. Thus, illustrated integrated circuit structure may be part of a larger integrated circuit that includes other integrated circuitry not depicted. Example materials and process parameters are given, but the present disclosure is not intended to be limited to any specific such materials or parameters, as will be appreciated. The use of the prime (') character denotes a figure having a different viewpoint at the same time in the process flow (e.g., Figures 2H and 2H' illustrate the structure at the same point in time from two different view points).

Figure 2A illustrates cross-sectional view taken through and perpendicular to a set of fins of semiconductor devices 102a - 102d extending from a substrate 104, according to an embodiment of the present disclosure. The previous relevant discussion with respect to example configurations and materials for the substrate 104 and the fins as well as dielectric fill 202 is equally applicable here. The fins can be native to the substrate, as illustrated, or non-native to the substrate, or multi-layer fins suitable for forming nanowires or nanoribbons. Likewise, the fins can be, for instance, alternating with respect to transistor polarity. For instance, the fin of semiconductor device 102a can include an NMOS material fin (e.g., silicon fin doped with p-type dopants) and the fin of semiconductor device 102b can include a PMOS material fin (e.g., SiGe fin or silicon fin doped with n-type dopants) for a first logic or memory cell. Likewise, the fins of semiconductor devices 102c and 102d can include a PMOS material fin and an NMOS material fin, respectively, for a second logic or memory cell. Numerous other configurations can be used, including fins included in integrated circuit sections other than memory or logic sections, such as analog mixed signal sections, input/output sections, radio frequency or transducer sections.

In this example case, a protective layer or cap 204 is left on the top of each fin, so as to provide the fins a degree of protection during subsequent processing. In cases where the fill dielectric 202 is an oxide (e.g., silicon dioxide), the cap 204 can be, for instance, a nitride, oxynitride, a carbide, or an oxycarbonitride so as to provide etch selectivity with respect to the fill dielectric 202. As can be further seen, a lithography mask 205 is patterned to provide an opening for a trench to be etched for where a buried power rail will be deposited. Lithography mask 205 can be any suitable mask such as, for instance, photoresist or one or more layers (e.g., carbon hard mask or an anti-reflective coating film or a silicon oxynitride) that provide the desired etch selectivity to allow for forming the trench. Note how mask 205 need not be perfectly aligned to the edge of caps 204, given like etch selectivities of mask 205 and caps 204 with respect to the trench etch scheme.

Any number of wet and/or dry etching techniques can be used to etch the trench where the buried power rail will be deposited. In this example case, the etch scheme includes a dielectric dry etch that is selective to cap 204 and mask 205, to remove any fill dielectric 202 (e.g., silicon dioxide) exposed by the opening in mask 205. Once the base of the substrate 104 is reached, the example etch scheme includes a reactive ion etch (RIE) to etch the remainder of the trench within the substrate 104 (e.g., the area below the dashed line). While dimensions can vary from one example embodiment to the next, in one example case, the total height from the bottom of the etched trench in substrate 104 to the top of cap 204 can be 250 nm or more, with the portion of substrate 104 etched by RIE being in the range of 50 to 100 nm, and with the fins thereabove having a height in the range of 50 to 200 nm (e.g., 60 to 130 nm), and the cap 204 having a height in the range of 5 to 75 nm. The width of the fins can be, for example, in the range of 5 to 200 nm. The pitch between neighboring fins can be, for example, in the range of 25 to 600 nm. In some such example embodiments, a width-to-height aspect ratio of the fins is in the range of about 1:5 to 1:50, such as the specific example case where the fins are about 5 nm wide at their mid-point, and about 200 nm tall, so as to provide a 1:40 width-to-height aspect ratio.

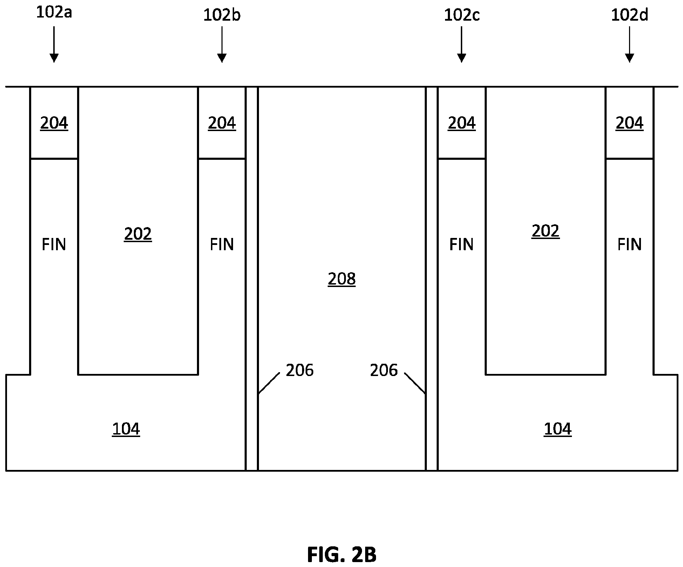

Figure 2B is the cross-sectional view of the structure depicted in Figure 2A, after removal of mask 205 and formation of dielectric liner 206 and the deposition of conductive material 208, according to an embodiment of the present disclosure. Mask 205 can be removed by any suitable means, such as a selective wet chemical etch. Once the structure is free of mask 205, dielectric liner 206 can be formed. In one example case, dielectric liner 206 is conformally deposited over the entire structure using atomic layer deposition (ALD) or chemical vapor deposition (CVD). The excess dielectric liner 206 material in the horizontal locations is then removed using a directional etch which in some embodiments is selective to the fill dielectric 202 and cap 204, but it need not be. The resulting dielectric liner 206 can have a thickness, for instance, in the range of 0.5 to 5 nm. In a more general sense, dielectric liner 206 can have any thickness suitable to insulate the conductive material 208 from touching the neighboring fins defining the sidewalls of the trench. In some example embodiments, dielectric liner 206 can be implemented with, for instance, an oxide, nitride, or carbide, such as silicon oxide or silicon nitride. In one such embodiment, where fill dielectric 202 is an oxide and cap 204 is silicon nitride, dielectric liner 206 is implemented with a dense silicon oxide, so as to provide a degree of etch selectivity with respect to fill dielectric 202 and cap 204.

Once dielectric liner 206 has been formed, conductive material 208 can be deposited by, for example, electroplating, CVD, PVD or ALD. Any excess amount of conductive material 208 extending out of the trench (e.g., above cap layer 204) can be polished away by way of a planarization/polishing technique such as chemical mechanical polishing (CMP). Conductive material 208 can be any number of conductive materials, such as tungsten, molybdenum, ruthenium, cobalt, copper, aluminum, silver, or alloys thereof. Further note that conductive material 208 can run parallel to the fins for any desired distance.

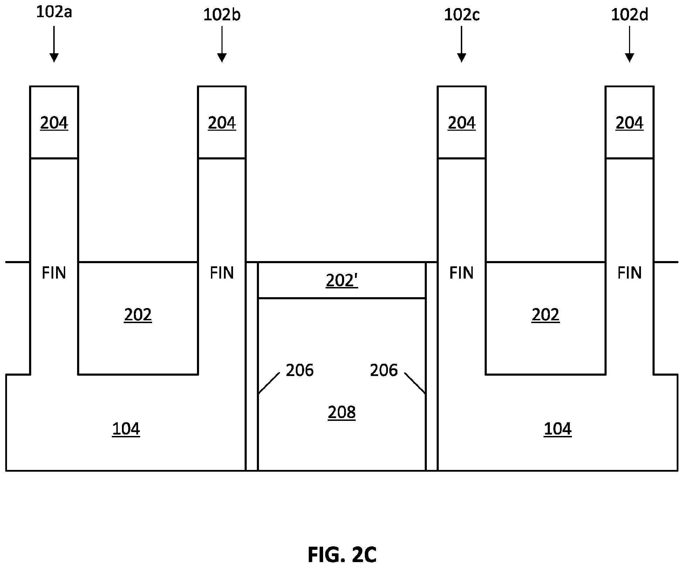

Figure 2C is the cross-sectional view of the structure depicted in Figure 2B, after recessing conductive material 208, followed by reforming another dielectric fill 202' over conductive material 208, according to an embodiment. In some example cases, the recessing of conductive material 208 is accomplished using an isotropic metal etch process selective to fill dielectric 202, cap 204, and dielectric liner 206. The depth of the recess will depend on the desired height of the final buried power rail, but in some example cases is in the range of 20 to 200 nm (e.g., 50 to 130 nm). The height of the recessed conductive material 208 can vary as well, but in some example cases, is in the range of about 20 to 500 nm (e.g., 30 to 90 nm).

Following the recess of conductive material 208, another dielectric fill 202' is deposited to fill the trench and is planarized before both dielectric fill 202 and dielectric fill 202' are recessed back together, according to an embodiment. In some embodiments, dielectric fill 202' is the same material as dielectric fill 202. Note that dielectric liner 206 is also recessed in this process. In some such cases, the fins are silicon, and fill dielectric 202 and 202' along with dielectric liner 206 are an oxide (e.g., silicon dioxide), so as to allow for a singular etch selectivity with respect to the silicon fins. In some example cases, the remaining thickness of fill dielectric 202' remaining above the recessed conductive material 208 is in the range of about 5 to 25 nm (e.g., 15 nm).

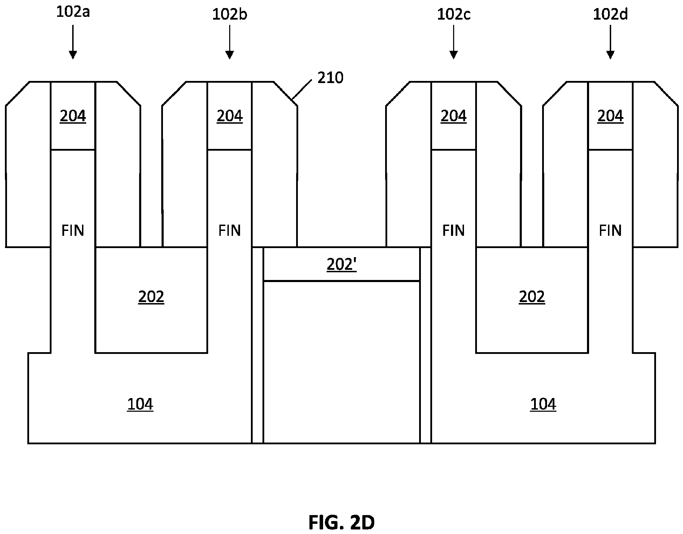

Figure 2D is the cross-sectional view of the structure depicted in Figure 2C, after the formation of spacer structures 210, according to an embodiment. Spacer structures 210 may be formed by initially depositing the spacer material over all exposed surfaces, and then etching back the spacer material using an anisotropic etching process (e.g., RIE). The directional etching process results in the spacer material being removed from horizontal surfaces, but remaining along the sidewalls of the fins and also on sidewalls of cap 204. Accordingly, the height of spacer structures 210 is determined by the thickness of cap 204 and the height of the fins that extend above the top surface of fill dielectric 202. Unlike typical gate spacers, spacer structures 210 comprise an amorphous semiconductor material, such as amorphous silicon (a-Si) or amorphous germanium (a-Ge), according to some embodiments. Although widths may vary based on the application, spacer structures 210 may have a width between about 5 nm and about 15 nm. The top corners of spacer structures 210 may be etched away and display a sloped profile (as illustrated) due to the etch-back process. As previously noted, Figure 2D may not be drawn to scale in that the height of cap 204 may be greater than the height of the fin that extends above the top surface of dielectric fill 202.

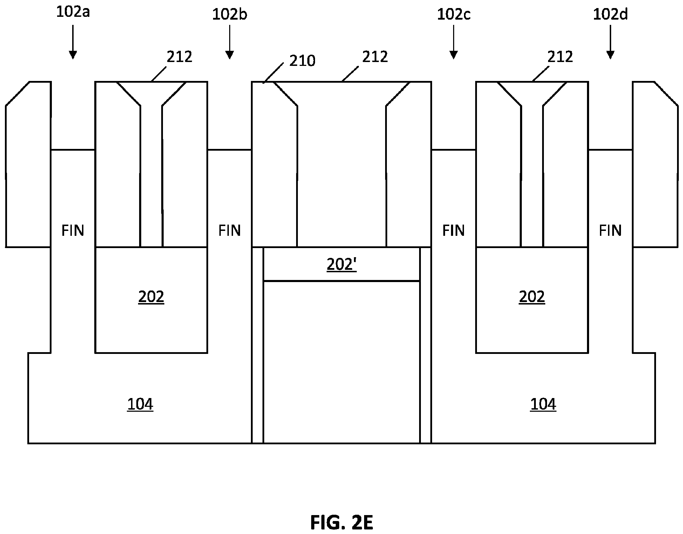

Figure 2E is the cross-sectional view of the structure depicted in Figure 2D, after the formation of fill material 212 and the removal of caps 204, according to an embodiment. Fill material 212 substantially fills the regions between adjacent spacer structures from adjacent semiconductor devices. According to some embodiments, fill material 212 marks locations for potential gate cuts in the final structure. Fill material 212 may be another semiconductor material that is different from the semiconductor material of spacer structures 210 such that there can be sufficient etch selectivity between fill material 212 and spacer structures 210. In some examples, fill material 212 is amorphous silicon germanium (a-SiGe) while spacer structures 210 are amorphous silicon (a-Si). In some other examples, both fill material 212 and spacer structures 210 include a-SiGe but with different germanium concentrations such that sufficient etch selectivity can be achieved between the two materials. Fill material 212 may be deposited using any conventional deposition technique, such as CVD, plasma-enhanced chemical vapor deposition (PECVD), or physical vapor deposition (PVD) followed by a polishing process (e.g., using CMP) to planarize the top surface of fill material 212.

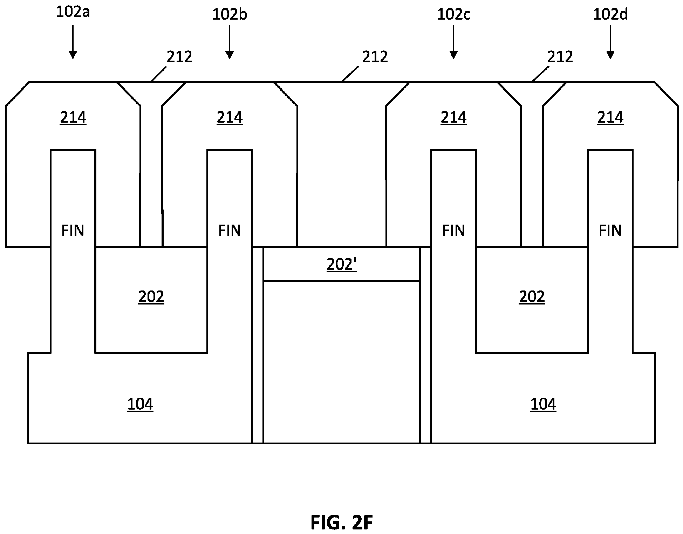

Figure 2F is the cross-sectional view of the structure depicted in Figure 2E, after filling the recesses left behind from the removal of caps 204 to form capping structures 214, according to an embodiment. According to some embodiments, the recesses are filled with the same material as spacer structures 210, such that capping structures 214 include the same material over the sidewalls and top surfaces of the fins. Accordingly, capping structures 214 may be composed of a-Si, a-Ge, or a-SiGe. The top surface of capping structures 214 may be planarized using one or more CMP processes. Multiple CMP stages may be used due to the unevenness of the capping structure material following its deposition.

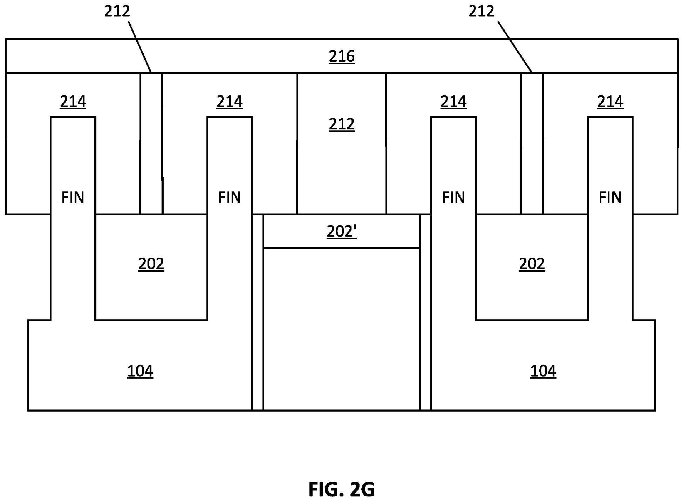

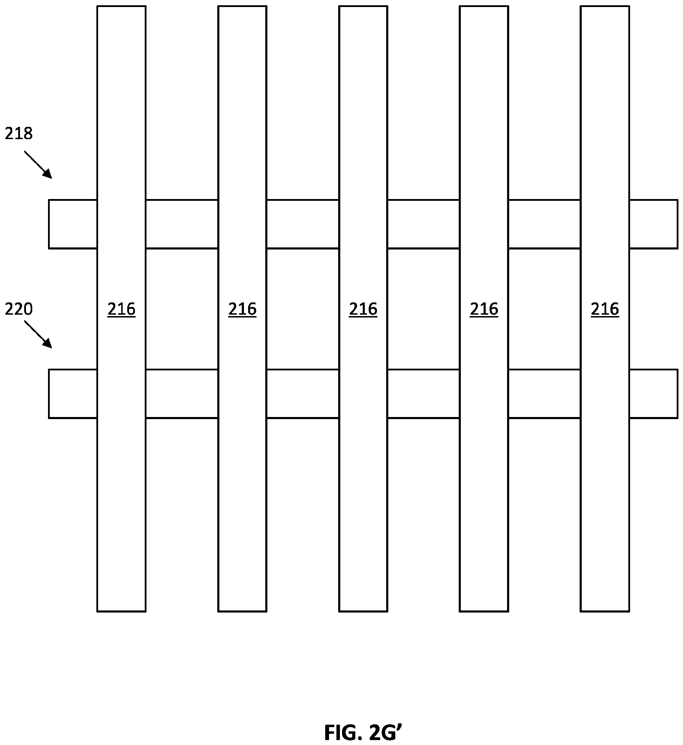

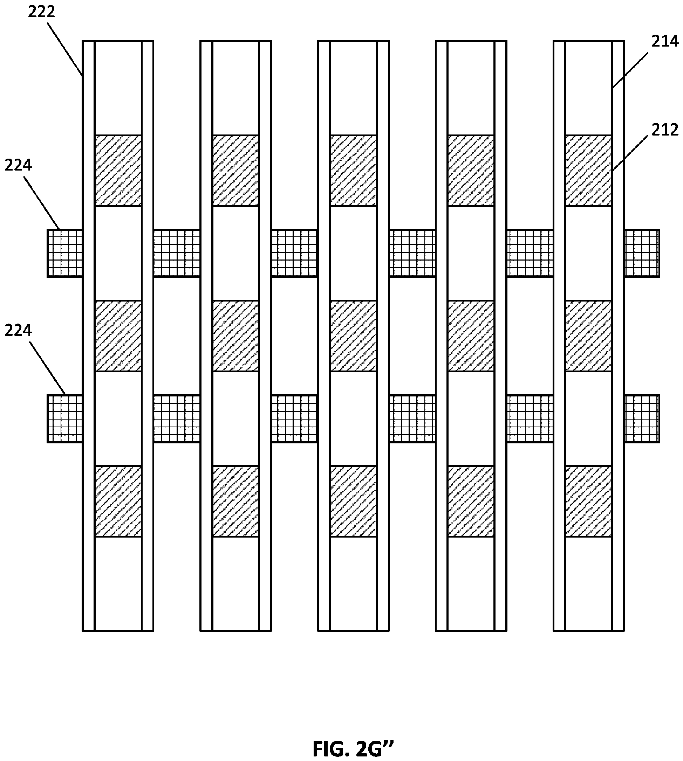

Figure 2G is the cross-sectional view of the structure depicted in Figure 2F, after polishing back below any sloped corners of capping structures 214 and depositing gate cap structures 216 to form additional transistor structures, according to an embodiment. Gate cap structures 216 may be strips of a dielectric material that run perpendicular to the lengths of the fins. In some embodiments, gate cap structures 216 include silicon nitride. Once gate cap structures 216 have been deposited and patterned into strips, additional transistor formation steps can take place to define locations of various transistors and form the source and drain regions for each of the transistors.

Figures 2G' and 2G" illustrate top-down views of the process used to define the transistor locations and the source/drain regions, according to some example embodiments. As seen in Figure 2G', gate cap structures 216 are patterned across different sections of fin 218 and fin 220. Once gate cap structures 216 are patterned, all other semiconductor material around fins 218 and 220 and not covered by gate cap structures 216 is etched away (fins 218 and 220 may be protected by a thin dielectric layer, such as a thin silicon oxide). Any of the preceding discussion with regards to semiconductor fins applies to both fin 218 and fin 220. The width of gate cap structures 216 defines the gate lengths of the transistors and may be anywhere in the range of 5 nm to 200 nm. Gate cap structures 216 may be patterned to be equidistant from one another (as illustrated), though this is not required.

Figure 2G" illustrates further transistor formation steps that are performed to define individual transistors along fins 218 and 220, according to some embodiments. Gate cap structures 216 are removed using, for example, dry or wet etchants that selectively remove the material of gate cap structures 216 (e.g., silicon nitride). Removal of the gate cap structures 216 exposes the pattern of fill material 212 and capping structures 214 that extend orthogonal to fins 218 and 220. According to some embodiments, capping structures 214 are observed over and around each fin while fill material 212 is observed between each adjacent pair of capping structures 214. Gate spacers 222 are formed along the sidewalls of the semiconductor material (e.g., both fill material 212 and capping structures 214) that had been masked by the gate cap structures 216. The gate spacers 222 may be formed using a similar etch-back process as the one used to form spacer structures 210. Gate spacers 222 may include a dielectric material, such as silicon nitride, silicon oxy-nitride, or any formulation of those layers incorporating carbon or boron dopants.

Following the formation of gate spacers 222, source or drain regions 224 are formed at the locations of the exposed portions of fins 218 and 220, according to some embodiments. The source and drain regions may be formed using any of the techniques discussed above.

According to some embodiments, the processes used to form the additional transistor structures, such as the formation of source or drain regions 224, may involve high temperature processes that affect the material of either or both fill material 212 and capping structures 214. In examples where either fill material 212 or capping structures 214 includes an amorphous material, the application of high temperatures may cause the amorphous material to partially crystalize and become a polycrystalline material. Thus, according to some embodiments, the amorphous silicon of capping structures 214 may become polysilicon and the amorphous silicon germanium of fill material 212 may become polycrystalline silicon germanium.

Figure 2H is the cross-sectional view of the structure depicted in Figure 2G, after forming a mask material 226, according to an embodiment. Mask material 226 may be used to expose certain regions of fill material 212 and protect other regions of fill material 212 as seen more clearly in Figure 2H'. Mask material 226 can be any type of photoresist or hard mask material, such as a carbon hard mask (CHM). Note that due to the etch selectively between fill material 212 and capping structures 214, mask material 226 does not require perfect alignment over fill material 212.

Figure 2H' illustrates a top-down view of the example structure depicted in Figure 2H where openings 228 in mask material 226 are identified by dashed lines. Masked material 226 itself is not shown for clarity. As is observed in the figure, some regions of fill material 212 are exposed as they are within any of openings 228 while other regions of fill material 212 are protected beneath mask material 226 (e.g., everywhere outside of the dashed boxes). Any mask material 226 pattern can be created to expose any number of regions of fill material 212.

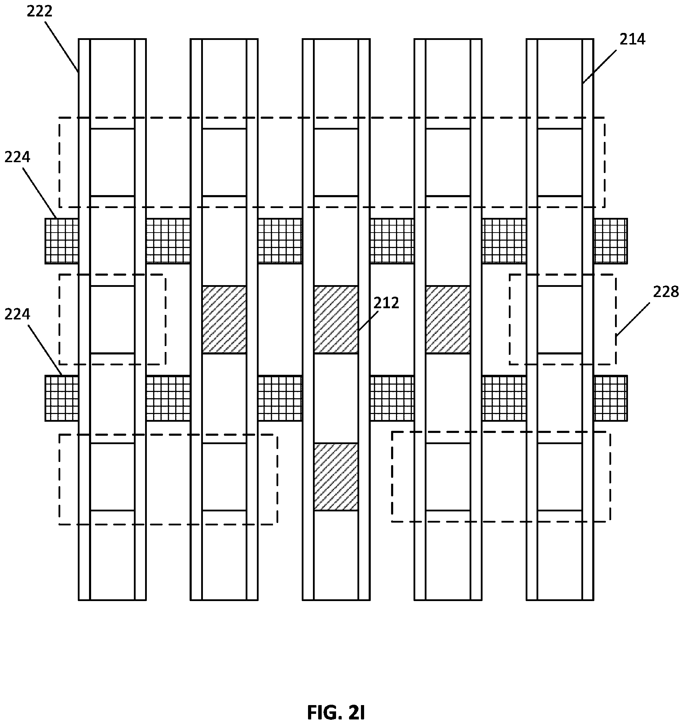

Figure 2I illustrates a top-down view of the structure depicted in Figure 2H' after removing the exposed regions of fill material 212, according to an embodiment. A wet or dry etchant process may be used to selectively remove fill material 212 while maintaining any exposed portions of capping structures 214. In an example where fill material 212 includes SiGe and capping structures 214 include Si, the SiGe may be etched in a plasma that includes CF4 at a microwave power between 600 W and 800 W and a pressure between about 300 mTorr and about 400 mTorr. Regions of fill material 212 that are protected by mask material 226 are unaffected by the etch. According to some embodiments, fill material 212 is removed in areas where gate cuts are to be formed.

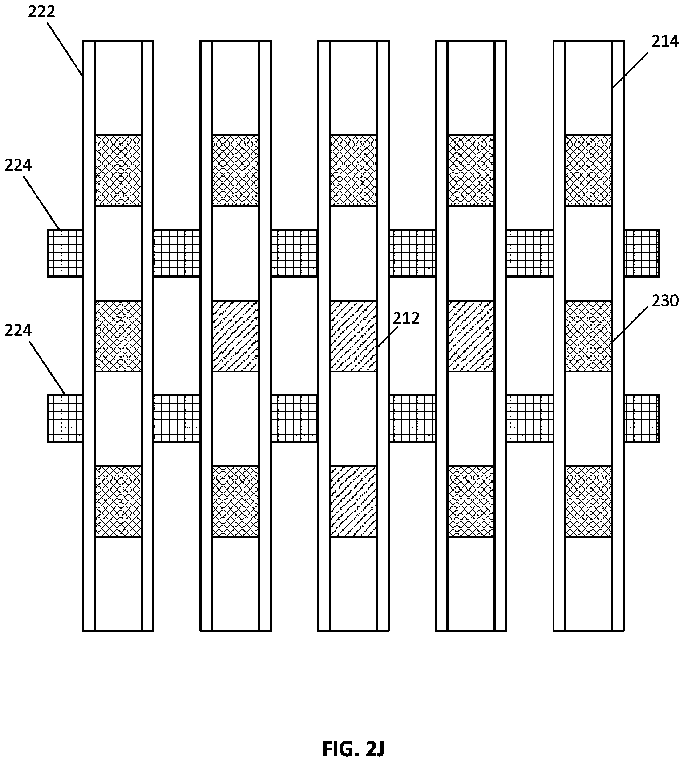

Figure 2J illustrates a top-down view of the structure depicted in Figure 2I after removing mask material 226 and forming gate cut structures 230 within the recesses left behind after removal of the exposed regions of fill material 212, according to an embodiment. According to some embodiments, gate cut structures 230 are formed using any standard deposition technique such as ALD, CVD, or some combination thereof. Gate cut structures 230 may be formed from any sufficiently electrically insulating material such as a dielectric material. In some embodiments, gate cut structures 230 comprise silicon nitride. The gate cut structure material may be polished back after deposition using, for example, CMP. At this stage, some regions between adjacent capping structures 214 include gate cut structures 230 while other regions include fill material 212. Any pattern of gate cut structures 230 and fill material 212 may be used depending on the integrated circuit design.

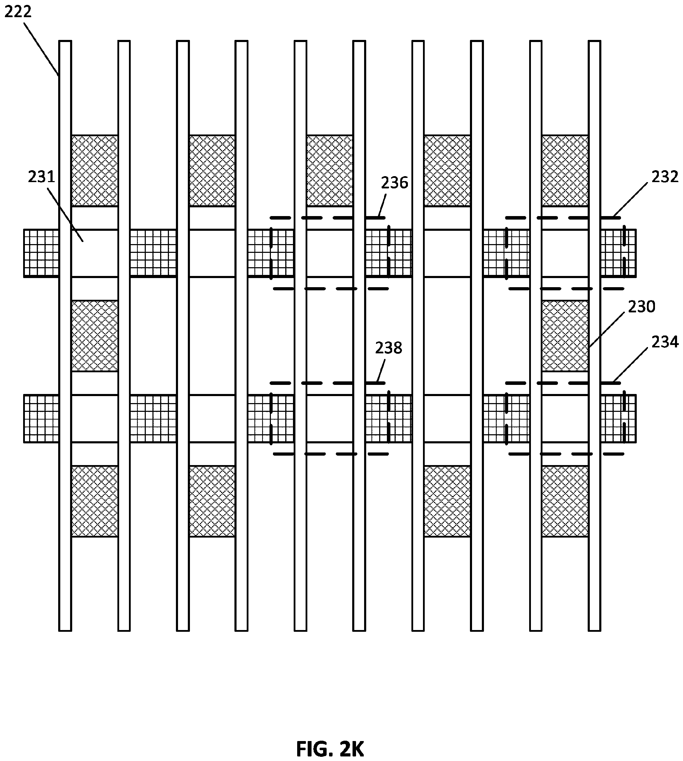

Figure 2K illustrates a top-down view of the structure depicted in Figure 2J after removing all fill material 212 and capping structures 214, according to an embodiment. A wet or dry etchant process may be used to remove both fill material 212 and capping structures 214 together. In an example where fill material 212 includes SiGe and capping structures 214 include Si, an anisotropic RIE process may be used to etch through both the SiGe and the Si at substantially the same rate. This RIE process may be similar to the one used to initially form the fins from substrate 104. Note that spacer structures 222 remain after the etching process to define the trenches where the gate material will be deposited.

The removal of capping structures 214 expose the fin portions of the various semiconductor devices. Four particular semiconductor devices 232 - 238 are identified in Figure 2K. In this example, due to the presence of gate cut structure 230, the gate of semiconductor device 232 will be isolated from the gate of semiconductor device 234. Additionally, in this example, since there is no gate cut structure 230 between semiconductor device 236 and semiconductor device 238, the gates of semiconductor devices 236 and 238 will be connected together. In this way, various semiconductor devices can either have their gates isolated from one another or connected together depending on the pattern of gate cut structures 230.

It should be noted that remaining steps to complete the formation of the semiconductor regions 231 of each semiconductor device may be performed at this stage of the process. In some examples, this includes the deposition of a gate dielectric layer over the exposed semiconductor regions 231 and/or removal of sacrificial layers in the case of GAA structures. The gate dielectric layer may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

Figure 2L illustrates a top-down view of the structure depicted in Figure 2K after forming gate layer 240 in all of the regions previously occupied by fill material 212 and capping structures 214, according to an embodiment. Gate layer 240 can include any conductive material, such as a metal, metal alloy, or polysilicon. Gate layer 240 may be deposited using electroplating, electroless plating, CVD, PECVD, ALD, or PVD, to name a few examples. According to some embodiments, gate layer 240 runs orthogonally over a plurality of parallel fins such that it extends over the semiconductor regions of a plurality of different semiconductor devices. According to some embodiments, each gate layer 240 may be interrupted by one or more of the gate cut structures 230 to electrically isolate various portions of gate layer 240 from one another. Figure 2L' illustrates a cross-section view of the same example structure from Figure 2L showing how gate cut structures 230a and 230b cut through the entire thickness of gate layer 240 between adjacent semiconductor devices.

As noted above, due to use of spacer structures 210 during the fabrication process of the sacrificial gate material, gate cut structures 230a and 230b are self-aligned at the midpoint between adjacent semiconductor devices. Also, since the size of a given gate cut structure is determined by the original distance between the adjacent semiconductor structures, gate cut structures of different sizes (e.g., different widths) can be formed across the integrated circuit. In the illustrated example, the left gate structure 230a is wider than the right gate cut structure 230b.

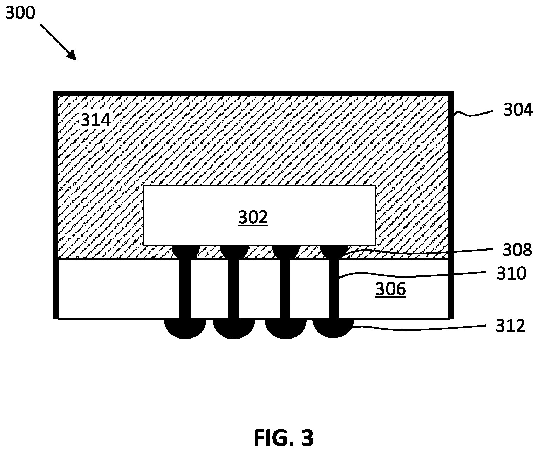

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

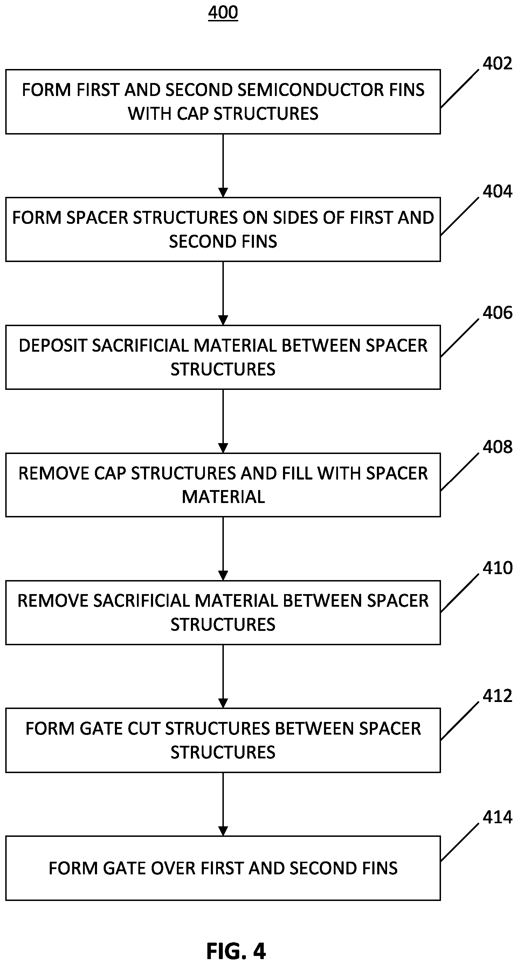

Figure 4 is a flow chart of a method 400 for forming at least a portion of an integrated circuit, according to an embodiment. Various operations of method 400 may be illustrated in Figures 2A - 2L'. However, the correlation of the various operations of method 400 to the specific components illustrated in the aforementioned figures is not intended to imply any structural and/or use limitations. Rather, the aforementioned figures provide one example embodiment of method 400. Other operations may be performed before, during, or after any of the operations of method 400. For example, method 400 does not explicitly describe many steps that are performed to form common transistor structures. Some of the operations of method 400 may be performed in a different order than the illustrated order.

Method 400 begins with operation 402 where at least first and second parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches. The fins also include a cap structure over each fin that is used to define the locations of the fins during, for example, an RIE process. The cap structure may be a dielectric material, such as silicon nitride.

Method 400 continues with operation 404 where spacer structures are formed on sidewall portions of at least the first and second fins, according to some embodiments. The spacer structures may also be formed along sidewall portions of the cap structures on the fins. The spacer structures may be formed by initially depositing the spacer material over all exposed surfaces, and then etching back the spacer material using an anisotropic etching process (e.g., RIE). The directional etching process results in the spacer material being removed from horizontal surfaces, but remaining along the sidewalls of the fins and also on sidewalls of the cap structures. Accordingly, the height of the spacer structures is determined by the thickness of the cap structures and the height of the fins that extend above the top surface of a fill dielectric (e.g., STI dielectric). Unlike typical gate spacers, these spacer structures include an amorphous semiconductor material, such as amorphous silicon (a-Si) or amorphous germanium (a-Ge), according to some embodiments.

Method 400 continues with operation 406 where a sacrificial material is deposited between adjacent spacer structures from adjacent fins (such as first and second fins), according to some embodiments. The sacrificial material marks locations for potential gate cuts in the final structure. The sacrificial material may be another semiconductor material that is different from the semiconductor material of the spacer structures such that there can be sufficient etch selectivity between the sacrificial material and the spacer structures. In some examples, the sacrificial material is amorphous silicon germanium (a-SiGe) while the spacer structures are amorphous silicon (a-Si). In some other examples, both the sacrificial material and the spacer structures include a-SiGe but with different germanium concentrations such that sufficient etch selectivity can be achieved between the two materials. The sacrificial material may be deposited using any conventional deposition technique, such as CVD, plasma-enhanced chemical vapor deposition (PECVD), Atomic Layer Deposition (ALD) or physical vapor deposition (PVD) followed by a polishing process (e.g., using CMP) to planarize the top surface of the sacrificial material.

Method 400 continues with operation 408 where the cap structures over the fins are removed and filled with the material used to form the spacer structures, according to some embodiments. The combination of the newly deposited material and the spacer structures can form capping structures composed of a-Si, a-Ge, or a-SiGe, to name a few examples, that wrap around the sides and top of the fins. The top surface of the capping structures may be planarized using one or more CMP processes.

Method 400 continues with operation 410 where the sacrificial material between the spacer structures is removed, according to some embodiments. An isotropic wet or dry etchant process may be used to selectively remove the sacrificial material while maintaining any exposed portions of the capping structures. In an example where the sacrificial material includes SiGe and the capping structures include Si, the SiGe may be etched in a plasma that includes CF4 at a microwave power between 600 W and 800 W and a pressure between about 300 mTorr and about 400 mTorr. Some regions of the sacrificial material may be protected by a mask material (such as a Carbon Hard Mask CHM) and are unaffected by the etch. According to some embodiments, the sacrificial material is removed in areas where gate cuts are to be formed.

Method 400 continues with operation 412 where gate cut structures are formed in the recesses created by the removal of the sacrificial material, according to some embodiments. The gate cut structures will ultimately act as the gate cuts after deposition of the gate layer. In some embodiments, the gate cut structures include silicon nitride or some other semiconductor nitride. Due to the formation of the spacer structures of substantially equal width, the gate cut structures will be self-aligned between adjacent fins without the need for any lithography-based alignment.

Method 400 continues with operation 414 where a gate layer is formed over at least the first and second fins after removal of the capping structures, according to some embodiments. The gate layer will be interrupted by the presence of any gate cut structures formed during operation 412, thus isolating the gates of semiconductor devices on either side of the gate cut structures. In one example where a gate cut structure is formed between the first and second fins, semiconductor devices formed from the first and second fins will have their gates isolated from one another due to the gate cut structure interrupting the gate layer across the first and second fins. The gate layer can include any conductive material, such as a metal, metal alloy, or polysilicon. The gate layer may be deposited using electroplating, electroless plating, CVD, ALD, PECVD, or PVD, to name a few examples.

### Example System

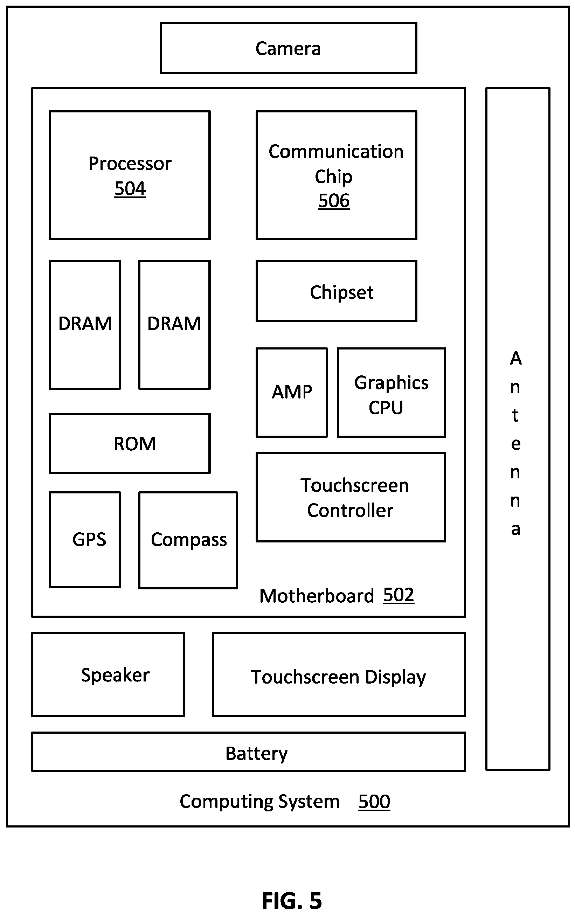

FIG. 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment (e.g., a module including an integrated circuit device on a substrate, the substrate having one or more semiconductor devices with gates isolated from each other using self-aligned gate cut structures, as variously provided herein). In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multi-standard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.
Example 1 is an integrated circuit that includes a first semiconductor device having a first semiconductor region extending between a first source region and a first drain region, a second semiconductor device having a second semiconductor region extending between a second source region and a second drain region, a gate layer comprising a conductive material and extending over the first semiconductor region and the second semiconductor region, and a gate cut structure comprising a dielectric material. The gate cut structure is between the first semiconductor device and the second semiconductor device such that the gate cut structure interrupts the gate layer. A first distance between the gate cut structure and the first semiconductor region is substantially the same as a second distance between the gate cut structure and the second semiconductor region.
Example 2 includes the subject matter of Example 1, wherein the first semiconductor region is a first fin comprising silicon or germanium or both, and the second semiconductor region is a second fin comprising silicon or germanium or both, the first fin orientated parallel to the second fin.
Example 3 includes the subject matter of Example 1 or 2, wherein the first semiconductor region comprises a first plurality of semiconductor nanoribbons and the second semiconductor region comprises a second plurality of semiconductor nanoribbons.
Example 4 includes the subject matter of Example 3, wherein the first plurality of semiconductor nanoribbons and the second plurality of semiconductor nanoribbons comprise germanium, silicon, or both.
Example 5 includes the subject matter of any one of Examples 1-4, wherein the first and second semiconductor devices are on or above a substrate, and the integrated circuit further comprises a buried conductive layer within or below the substrate and below the gate cut structure.
Example 6 includes the subject matter of any one of Examples 1-5, wherein the dielectric material comprises silicon and nitrogen or comprises silicon and oxygen.
Example 7 includes the subject matter of any one of Examples 1-6, wherein the gate cut structure is a first gate cut structure and the integrated circuit further comprises a second gate cut structure between the second semiconductor device and a third semiconductor device.
Example 8 includes the subject matter of Example 7, wherein the first gate cut structure has a first width and the second gate cut structure has a second width that is smaller than the first width.
Example 9 includes the subject matter of any one of Examples 1-8, wherein the first distance between the gate cut structure and the first semiconductor region is within 1 nm of the second distance between the gate cut structure and the second semiconductor region.
Example 10 includes the subject matter of any one of Examples 1-9, wherein the first distance between the gate cut structure and the first semiconductor region is within 5 angstroms of the second distance between the gate cut structure and the second semiconductor region.
Example 11 includes the subject matter of any one of Examples 1-10, wherein the gate cut structure has a width between about 5 nm and about 20 nm.
Example 12 is a printed circuit board comprising the integrated circuit of any one of Examples 1-11.
Example 13 is an electronic device that includes a chip package having one or more dies. At least one of the one or more dies includes a first semiconductor device having a first semiconductor region extending between a first source region and a first drain region, a second semiconductor device having a second semiconductor region extending between a second source region and a second drain region, a gate layer comprising a conductive material and extending over the first semiconductor region and the second semiconductor region, and a gate cut structure comprising a dielectric material. The gate cut structure is between the first semiconductor device and the second semiconductor device such that the gate cut structure interrupts the gate layer. A first distance between the gate cut structure and the first semiconductor region is substantially the same as a second distance between the gate cut structure and the second semiconductor region.
Example 14 includes the subject matter of Example 13, wherein the first semiconductor region is a first fin comprising silicon or germanium or both, and the second semiconductor region is a second fin comprising silicon or germanium or both, the first fin orientated parallel to the second fin.
Example 15 includes the subject matter of Example 13 or 14, wherein the first semiconductor region comprises a first plurality of semiconductor nanoribbons and the second semiconductor region comprises a second plurality of semiconductor nanoribbons.
Example 16 includes the subject matter of Example 15, wherein the first plurality of semiconductor nanoribbons and the second plurality of semiconductor nanoribbons comprise germanium, silicon, or both.
Example 17 includes the subject matter of any one of Examples 13-16, wherein the first and second semiconductor devices are on or above a substrate, and the integrated circuit further comprises a buried conductive layer within or below the substrate and below the gate cut structure.
Example 18 includes the subject matter of any one of Examples 13-17, wherein the dielectric material comprises silicon and nitrogen or comprises silicon and oxygen.
Example 19 includes the subject matter of any one of Examples 13-18, wherein the gate cut structure is a first gate cut structure and the integrated circuit further comprises a second gate cut structure between the second semiconductor device and a third semiconductor device.
Example 20 includes the subject matter of Example 19, wherein the first gate cut structure has a first width and the second gate cut structure has a second width that is smaller than the first width.
Example 21 includes the subject matter of any one of Examples 13-20, wherein the gate cut structure has a width between about 5 nm and about 20 nm.
Example 22 includes the subject matter of any one of Examples 13-21, wherein the electronic device further comprises a printed circuit board, wherein the chip package is attached to the printed circuit board.
Example 23 is a method of forming an integrated circuit. The method includes forming a first fin comprising first semiconductor material and a second fin comprising second semiconductor material, wherein the first fin and the second fin extend parallel to one another, the first fin having a first cap structure on a top surface of the first fin and the second fin having a second cap structure on a top surface of the second fin; forming a first spacer structure comprising a first material on at least a first side of the first fin facing the second fin and a second spacer structure comprising the first material on at least a second side of the second fin facing the first fin; depositing a second material different from the first material into a region between the first and second spacer structures; removing the cap structure and depositing the first material onto the top surface of the first fin and the second fin; removing the second material from between the first and second spacer structures; depositing a dielectric material into the region between the first and second spacer structures; and forming a gate over the first semiconductor material and over the second semiconductor material, wherein the dielectric material interrupts the gate between the first semiconductor material and the second semiconductor material.
Example 24 includes the subject matter of Example 23, wherein forming the first fin and the second fin comprises recessing a dielectric layer between the first and the second fins such that the first and the second fins extend above a top surface of the dielectric layer.
Example 25 includes the subject matter of Example 23 or 24, wherein a first distance between the dielectric material and the first semiconductor material is substantially the same as a second distance between the dielectric material and the second semiconductor material.
Example 26 includes the subject matter of any one of Examples 23-25, wherein the first material comprises amorphous silicon and the second material comprises amorphous silicon and germanium.
Example 27 includes the subject matter of Example 26, further comprising converting the amorphous silicon of the first material into polysilicon and converting the amorphous silicon and germanium of the second material into polycrystalline silicon and germanium.
Example 28 includes the subject matter of any one of Examples 23-27, wherein the first fin and the second fin are formed on a substrate, and the method further comprises forming a buried conductive layer within the substrate.
Example 29 includes the subject matter of Example 28, wherein the region between the first and second spacer structures is over the buried conductive layer.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending between a first source region and a first drain region;
a second semiconductor device having a second semiconductor region extending between a second source region and a second drain region;
a gate layer comprising a conductive material, the gate layer extending over the first semiconductor region and the second semiconductor region; and
a gate cut structure comprising a dielectric material, the gate cut structure being between the first semiconductor device and the second semiconductor device such that the gate cut structure interrupts the gate layer, wherein a first distance between the gate cut structure and the first semiconductor region is substantially the same as a second distance between the gate cut structure and the second semiconductor region.

2. The integrated circuit of claim 1, wherein the first semiconductor region is a first fin comprising silicon or germanium or both, and the second semiconductor region is a second fin comprising silicon or germanium or both, the first fin orientated parallel to the second fin.

3. The integrated circuit of claim 1 or 2, wherein the first semiconductor region comprises a first plurality of semiconductor nanoribbons and the second semiconductor region comprises a second plurality of semiconductor nanoribbons.

4. The integrated circuit of claim 3, wherein the first plurality of semiconductor nanoribbons and the second plurality of semiconductor nanoribbons comprise germanium, silicon, or both.

5. The integrated circuit of any one of claims 1 through 4, wherein the first and second semiconductor devices are on or above a substrate, and the integrated circuit further comprises a buried conductive layer within or below the substrate and below the gate cut structure.

6. The integrated circuit of any one of claims 1 through 5, wherein the dielectric material comprises silicon and nitrogen or comprises silicon and oxygen.

7. The integrated circuit of any one of claims 1 through 6, wherein the gate cut structure is a first gate cut structure and the integrated circuit further comprises a second gate cut structure between the second semiconductor device and a third semiconductor device.

8. The integrated circuit of claim 7, wherein the first gate cut structure has a first width and the second gate cut structure has a second width that is smaller than the first width.

9. The integrated circuit of any one of claims 1 through 8, wherein the first distance between the gate cut structure and the first semiconductor region is within 1 nm of the second distance between the gate cut structure and the second semiconductor region.

10. The integrated circuit of any one of claims 1 through 9, wherein the first distance between the gate cut structure and the first semiconductor region is within 5 angstroms of the second distance between the gate cut structure and the second semiconductor region.

11. The integrated circuit of any one of claims 1 through 10, wherein the gate cut structure has a width between about 5 nm and about 20 nm.

12. A printed circuit board comprising the integrated circuit of any one of claims 1 through 11.

13. A method of forming an integrated circuit, comprising:
forming a first fin comprising first semiconductor material and a second fin comprising second semiconductor material, wherein the first fin and the second fin extend parallel to one another, the first fin having a first cap structure on a top surface of the first fin and the second fin having a second cap structure on a top surface of the second fin;
forming a first spacer structure comprising a first material on at least a first side of the first fin facing the second fin and a second spacer structure comprising the first material on at least a second side of the second fin facing the first fin;
depositing a second material different from the first material into a region between the first and second spacer structures;
removing the cap structure and depositing the first material onto the top surface of the first fin and the second fin;
removing the second material from between the first and second spacer structures;
depositing a dielectric material into the region between the first and second spacer structures; and
forming a gate over the first semiconductor material and over the second semiconductor material, wherein the dielectric material interrupts the gate between the first semiconductor material and the second semiconductor material.

14. The method of any one of claims 19 through 21, wherein the first material comprises amorphous silicon and the second material comprises amorphous silicon and germanium, the further comprising converting the amorphous silicon of the first material into polysilicon and converting the amorphous silicon and germanium of the second material into polycrystalline silicon and germanium.

15. The method of 13 or 14, wherein the first fin and the second fin are formed on a substrate, and the method further comprises forming a buried conductive layer within the substrate, wherein the region between the first and second spacer structures is over the buried conductive layer.
